# EUROPEAN PATENT APPLICATION

(11) **EP 2 525 631 A2**
(43) Date of publication of application: **21.11.2012**
(21) Application number: 11007138.8
(22) Date of filing: 02.09.2011
(51) Int. Cl.: H05H 1/44, H05H 1/48

(54) **Plasma nano-powder synthesizing and coating device and method of the same**

(30) Priority: 20.05.2011 KR 20110048161
(71) Applicant: Korea Institute of Energy Research, Yuseong-Gu Daejeon (KR)
(72) Inventor: Kim, Jong-Huy, Yuseong-gu Daejeon (KR); Lee, Hyeong-Jae, Yuseong-gu Daejeon (KR); Kim, Yong-Il, Jung-gu Daejeon (KR)
(74) Representative: Zeitler, Giselher

(57) **Abstract**

Disclosed are a plasma nano-powder synthesizing and coating device and method, the device comprising: a chamber which forms a sealed space, and comprises a reaction unit provided at one side and a processing unit provided at the other side, the reaction unit provided in an upstream of gas flowing in the chamber, having a high-temperature plasma region formed by a plasma torch generating plasma with an applied electric current, and comprising a mixed gas feeder to supply mixed gas to the reaction unit and a powder feeder to supply powder to the reaction unit, and the processing unit provided in a downstream of plasma flame in the chamber, and comprising a supporter to support a material; and a vacuum forming unit which forms a vacuum inside the chamber, the powder being supplied to the reaction unit and reacting in the plasma region of the reaction unit, and the reacted powder being synthesized in the reaction unit, the processing unit and a surface of the supporter, and coated on a surface of the material of the supporter to form a coating layer.

With this, reaction, synthesis and coating of heterogeneous powder are simultaneously performed, and various reaction conditions can be simply and conveniently controlled.

## Description

### CROSS-REFERENCE TO RELATED APPLICATION

This application claims priority from Korean Patent Application No. 10-2011-0048161, filed on May 20, 2011 in the Korean Intellectual Property Office, the disclosure of which is incorporated herein by reference.

### BACKGROUND

### Field

Apparatuses and methods consistent with the exemplary embodiments relate to a plasma nano-powder synthesizing and coating device and a method of the same, and more particularly to a plasma nano-powder synthesizing and coating device and a method of the same, in which various conditions for phase change such as evaporation, melting, etc. of supplied nano-powder can be formed; two or many kinds of metals or metal-carbon, ceramics, etc. can be produced or synthesized under various conditions; and the synthesized powder can be coated on or collected from a desired material.

### Description of the Related Art

A method of synthesizing and at the same time thin-film growing or coating a material having various chemical components and crystal structures in an evaporation phase is broadly divided into chemical vapor deposition and physical vapor deposition.

In the chemical vapor deposition, reaction gas supplied to a reaction chamber grows as a thin film on a top surface of a material such as a heated wafer through chemical reaction. Such a thin-film growing method based on the chemical vapor deposition is more excellent in quality of grown crystal than liquid phase epitaxy, but has shortcomings that the crystal relatively slow grows. To overcome these shortcomings, there has been widely employed a method of simultaneously growing many sheets of substrates in a single growth cycle. Further, a conventional method needs sequential processes where a primary thin film is formed and then a secondary thin film is grown in the case of growing different metals, and has features that the thin film has compact texture.

In the physical vapor deposition, a solid target containing elements constituting a thin film is made into gaseous atoms or ions or a cluster of them through a physical action, and they are moved by an electromotive force of an electric field formed between the target and a substrate, so that a thin film can be formed on the substrate or at a predetermined depth of the substrate. This deposition is simple, but a high-degree vacuum is needed for decreasing contamination since the atoms to be deposited are straight flying from a source along the electric field, or the deposition of uniform thickness is not achieved if the surface of the substrate is uneven.

Meanwhile, as one of methods of coating a thin film in a gas phase, there is an arc-plasma spray coating method. The principle is as follows: high temperature plasma generated by an electric arc, i.e., a strong electric discharge acrossing gas flow, melts a metal or ceramic material, and then the melted material is sprayed on to a substrate by plasma spray flow, thereby forming a coating layer on a surface of the substrate.

However, the coating layer formed by such a plasma spray coating method has a very dense structure with one kind of metal particles coated on a surface of a mother body since one kind of metal is melted and then sprayed using the high-speed spraying flow.

Accordingly, in the plasma spray coating method, there is required a method of synthesizing more various kinds of particles such as carbon, ceramic or the like as well as metal and is required a method of coating the synthesized particles on to a surface of a substrate or the like material in proper density. Also, it may be preferable if the size and phase-change of powder synthesized in this process are variously controllable, and in the case of a synthesized-powder coating layer, it may be further preferable if a condition for controlling the density or porosity of the coated layer can be formed. Furthermore, it may be preferable if the powder changed in phase such as evaporation, melting or the like is simply and conveniently collected.

### SUMMARY

Accordingly, one or more exemplary embodiments provide a plasma nano-powder synthesizing and coating device and a method of the same, in which a high-temperature range of plasma can be variously, simply and conveniently controlled in accordance with the kind of powder and various synthesizing conditions of the device.

Another exemplary embodiment is to provide a plasma nano-powder synthesizing and coating device and a method of the same, in which heterogeneous powder can be simply and conveniently synthesized in a plasma range.

Still another exemplary embodiment is to provide a plasma nano-powder synthesizing and coating device and a method of the same, in which heterogeneous powder can be simultaneously synthesized and coated.

Still another exemplary embodiment is to provide a plasma nano-powder synthesizing and coating device and a method of the same, in which the size and porosity of metal to be coated are controllable.

Still another exemplary embodiment is to provide a plasma nano-powder synthesizing and coating device and a method of the same, in which powder can have a higher purity.

Still another exemplary embodiment is to provide a plasma nano-powder synthesizing and coating device and a method of the same, in which supplied or reacted powder can be simply and conveniently collected.

Still another exemplary embodiment is to provide a plasma nano-powder synthesizing and coating device and a method of the same, in which a film-shaped material can be successively coated.

The foregoing and/or other aspects may be achieved by providing a plasma nano-powder synthesizing and coating device comprising: a chamber which forms a sealed space, and comprises a reaction unit provided at one side and a processing unit provided at the other side, the reaction unit provided in an upstream of gas flowing in the chamber, having a high-temperature plasma region formed by a plasma torch generating plasma with an applied electric current, and comprising a mixed gas feeder to supply mixed gas to the reaction unit and a powder feeder to supply powder to the reaction unit, and the processing unit provided in a downstream of gas flowing in the chamber, and comprising a supporter to support a material; and a vacuum forming unit which forms a vacuum inside the chamber, the powder being supplied to the reaction unit and reacting in the plasma region of the reaction unit, and the reacted powder being synthesized in the reaction unit, the processing unit and a surface of the supporter, and coated on a surface of the material of the supporter to form a coating layer.

The powder supplied from the powder feeder may comprise a plurality of powders, and the powder being supplied may comprise different kinds of powders among metal powder, carbon, ceramic and inorganic powder.

The plasma nano-powder synthesizing and coating device may further comprise a nozzle unit provided between the reaction unit and the processing unit and detachable to the chamber so that a channel can be adjusted in width and length.

The plasma nano-powder synthesizing and coating device may further comprise a reaction region collecting unit provided between the nozzle unit and the reaction unit and comprising a cooling member capable of exchanging heat with powder so that the powder circulating between the nozzle unit and an inner wall of the reaction unit can be collected.

The plasma nano-powder synthesizing and coating device may further comprise a processing region powder collecting unit provided in the processing unit and arranged in the vicinity of the supporter to collect the powder scattered from the reaction unit.

The plasma nano-powder synthesizing and coating device may further comprise an auxiliary powder collecting unit interposed between the chamber and the vacuum forming unit and collecting the powder scattered outside the chamber.

The plasma nano-powder synthesizing and coating device may further comprise a flow control unit provided in a pipe between the chamber and the vacuum forming unit and controlling a flow rate in the pipe so that a degree of a vacuum in the chamber and so a plasma state in the reaction unit can be adjusted.

The material supported by the supporter may have a film shape, and be provided to be unwound at one side but wound at the other side so that a surface of the material can be coated while the material moves.

The plasma torch may be provided in plural to equally branch without being aligned on the axis of the reaction unit and arranged above the reaction unit, each plasma torch synthesizing and forming the plasma region along the axial region of the reaction unit, and the powder feeder may be arranged above the reaction unit so that the powder can be supplied to the plasma region formed along the axial region of the reaction unit.

Another aspect may be achieved by providing a plasma nano-powder synthesizing and coating method comprising: forming a high-temperature plasma region by a plasma torch generating plasma with an electric current supplied to a reaction unit in a chamber which has a sealed space and comprises the reaction unit at one side and a processing unit at the other side; supplying mixed gas to the reaction unit; forming a vacuum inside the chamber; supplying powder to the reaction unit; making the powder react in the plasma region; and synthesizing the reacted powder on a surface of a material supported and provided in the processing unit.

The powder may comprise different kinds of powders among metal powder, carbon, ceramic and inorganic powder.

The plasma nano-powder synthesizing and coating method may further comprise collecting the powder scattered in the reaction unit in the vicinity of the processing unit.

The plasma nano-powder synthesizing and coating method may further comprise controlling reaction or synthesis of the powder in the reaction unit by adjusting at least one of a degree of a vacuum inside the chamber, an electric current applied to the plasma torch, and the flow rate of mixed gas supplied from a mixed gas feeder.

The plasma nano-powder synthesizing and coating method may further comprise controlling a coating layer coated on a surface of a material by adjusting at least one of a degree of a vacuum inside the chamber, an electric current supplied to the plasma torch, and an flow rate of mixed gas supplied from a mixed gas feeder.

The metal powder may comprise aluminum, nickel and other metal particles.

The mixed gas may comprise one of reduction gas, hydrocarbon gas and inert gas.

The plasma nano-powder synthesizing and coating method may further comprise collecting the powder solidified inside the chamber or cold-trapped in the pipe to the vacuum forming unit.

The plasma nano-powder synthesizing and coating method may further comprise preparing a nozzle unit provided between the reaction unit and the processing unit and detachable to the chamber so that a channel can be adjusted in width and length.

The plasma nano-powder synthesizing and coating method may further comprise preparing a reaction region collecting unit provided between the nozzle unit and the reaction unit and comprising a cooling member capable of exchanging heat with powder so that the powder recirculating in the space between the nozzle unit and an inner wall of the reaction unit can be solidified and collected.

The material supported by the supporter may have a film shape and be provided to be unwound at one side but wound at the other side, the method may further comprising coating a surface of the material while the material moves.

The plasma nano-powder synthesizing and coating method may further comprise providing the plasma torch in plural to equally branch without being aligned on the axis of the reaction unit and arranged above the reaction unit, each plasma torch forming the plasma region along the axial region of the reaction unit, and arranging a powder feeder above the reaction unit so that the powder can be supplied to the plasma region formed along the axis of the reaction unit.

### BRIEF DESCRIPTION OF THE DRAWINGS

The above and/or other aspects will become apparent and more readily appreciated from the following description of the exemplary embodiments, taken in conjunction with the accompanying drawings, in which:
FIG. 1 is a view showing a schematic flow according to an exemplary embodiment;
FIG. 2A is a partial enlarged view of FIG. 1;
FIG. 2B is a schematic view for explaining a nozzle unit;
FIG. 2C is a partial enlarged view showing another exemplary embodiment;
FIG. 2D is a partial perspective view showing another exemplary embodiment;
FIGs. 3A, 3B and 3C are photographs showing plasma flames taken at respective positions inside a chamber as conditions in the chamber are changed;
FIGs. 4A to 4D are graphs showing temperature variation depending on change in the conditions;
FIGs. 5A and 5B are photographs showing particles of aluminum powder before and after reaction according to an exemplary embodiment; and
FIG. 6 is a flowchart of a plasma nano-powder synthesizing and coating method according to an exemplary embodiment.

### DETAILED DESCRIPTION OF EXEMPLARY EMBODIMENTS

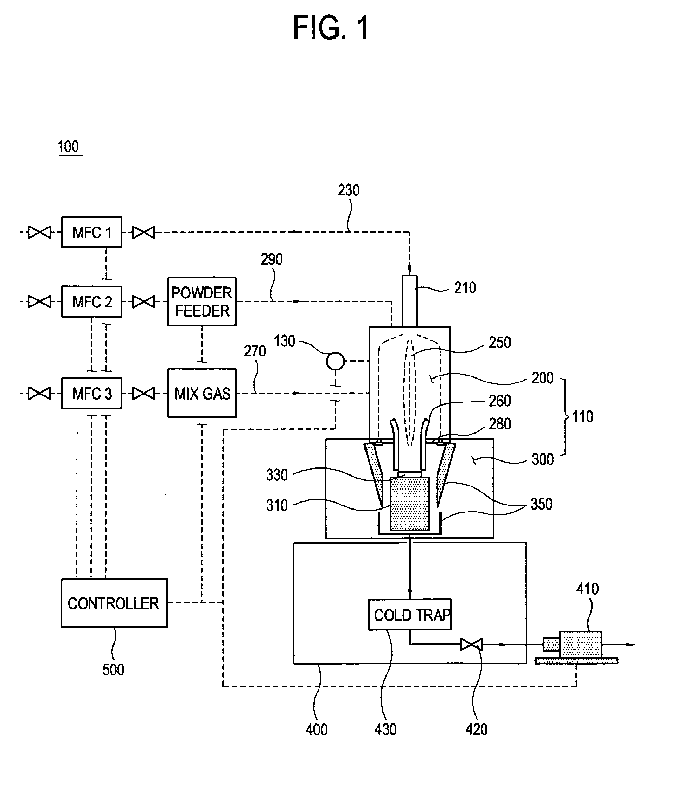

Below, a plasma nano-powder synthesizing and coating device and a method of the same according to an exemplary embodiment will be described in detail with reference to FIGs. 1 to 6.

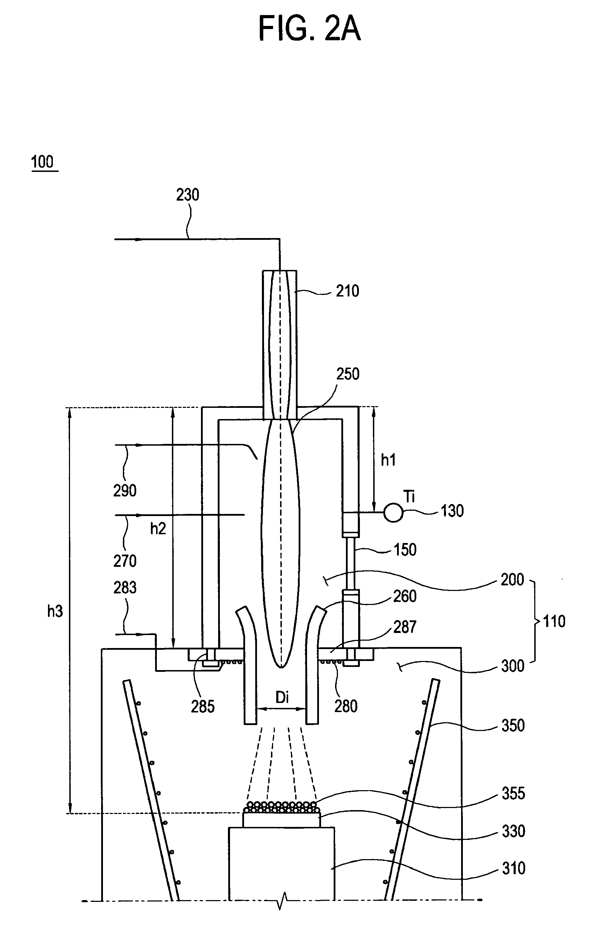

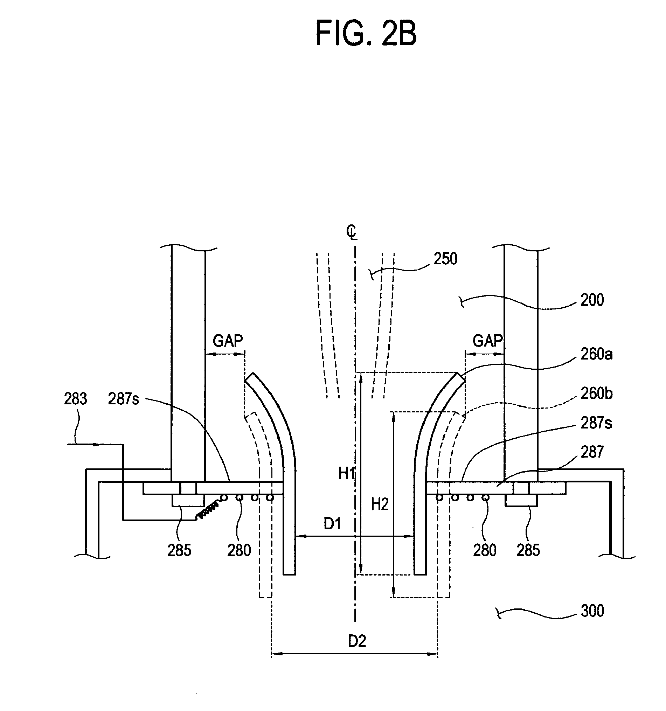

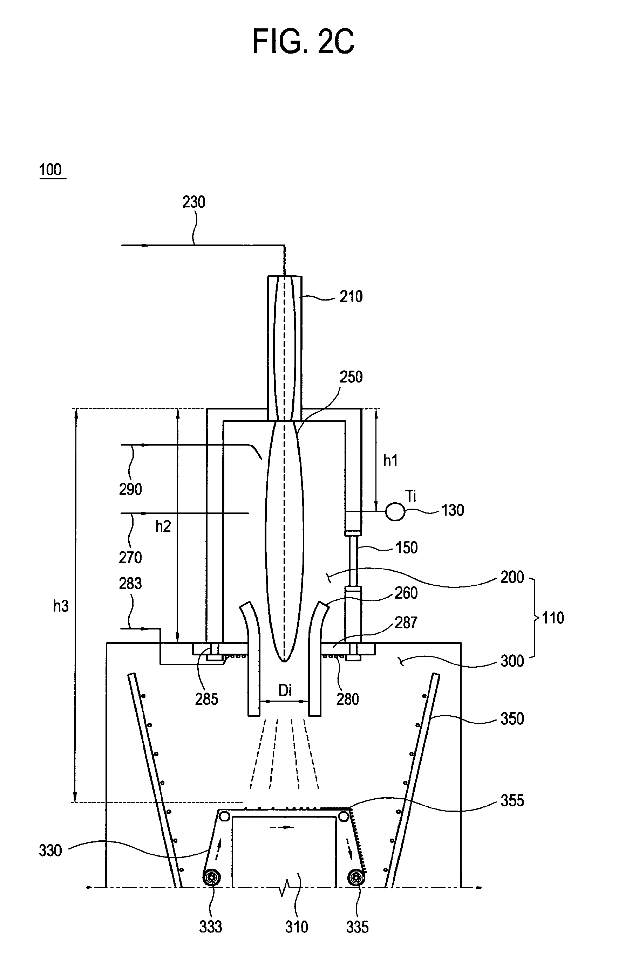

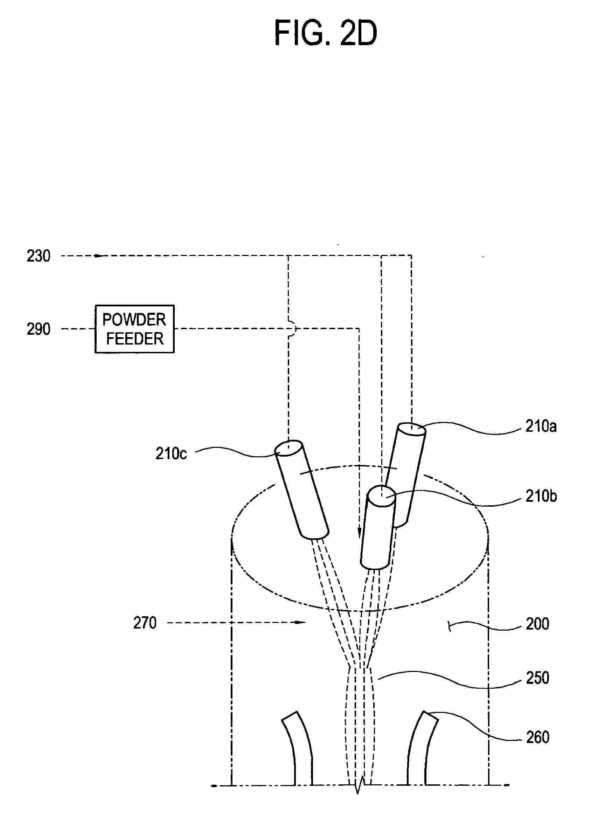

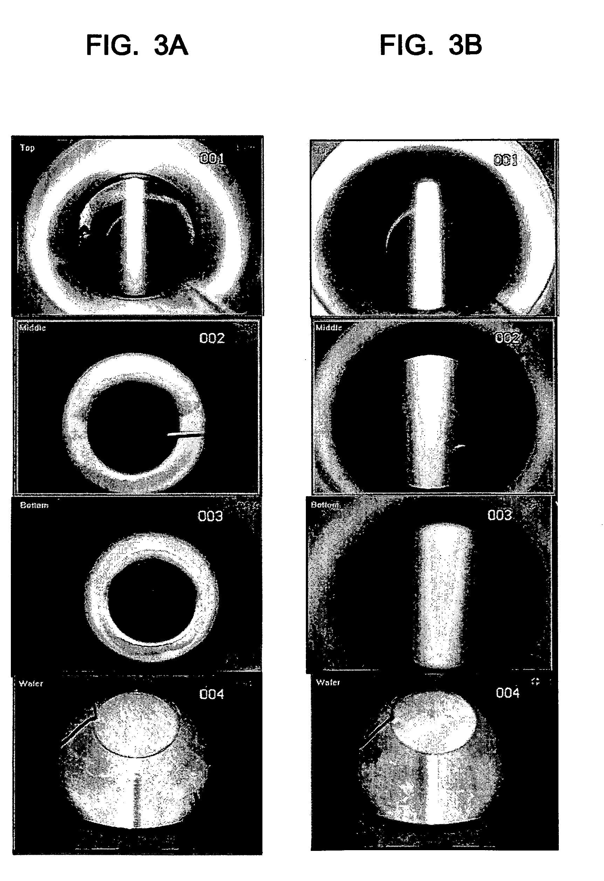

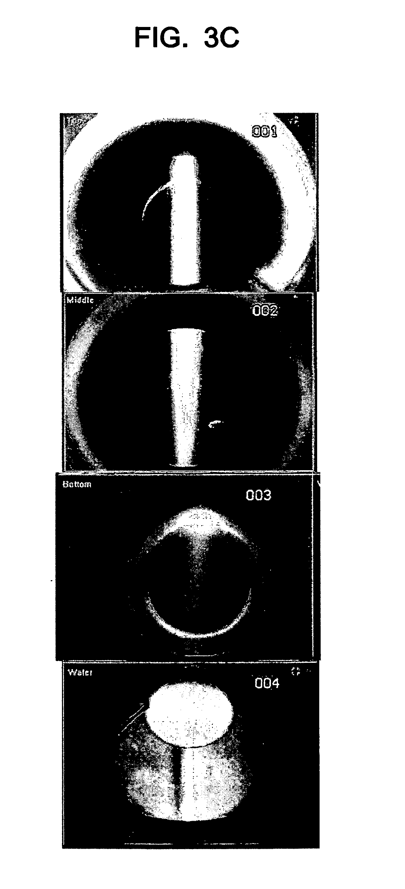

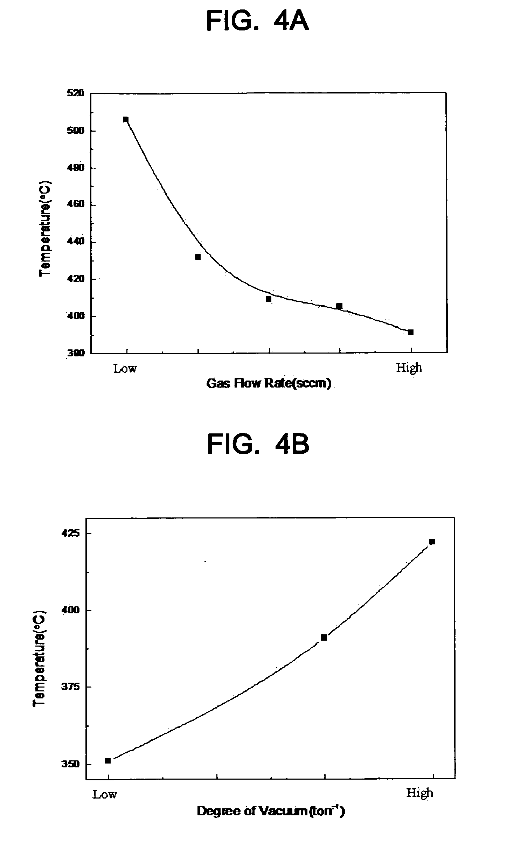

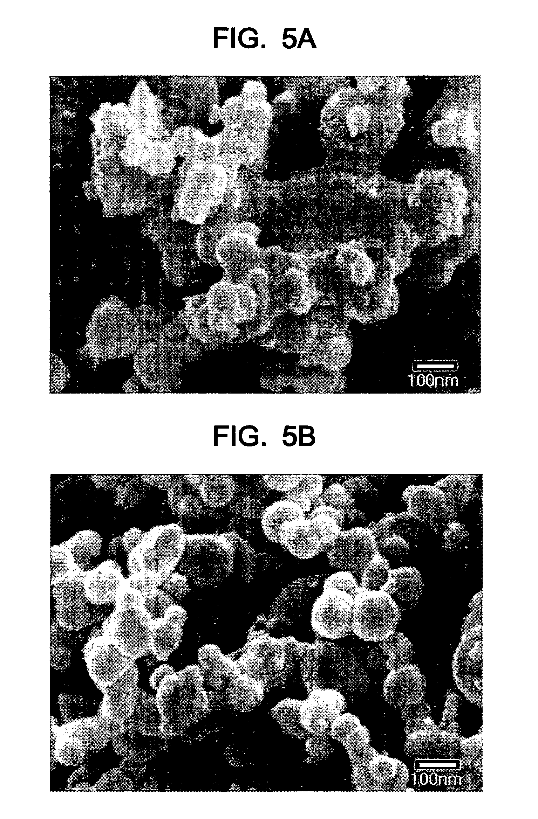

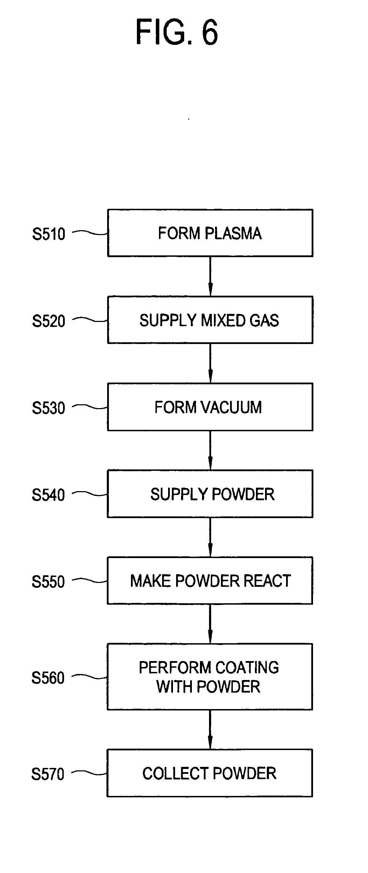

FIG. 1 is a view showing a schematic flow according to an exemplary embodiment, FIG. 2A is a partial enlarged view of FIG. 1; FIG. 2B is a schematic view for explaining a nozzle unit; FIG. 2C is a partial enlarged view showing another exemplary embodiment; FIG. 2D is a partial perspective view showing another exemplary embodiment; FIGs. 3A, 3B and 3C are photographs showing plasma flames taken at respective positions inside a chamber as conditions in the chamber are changed; FIGs. 4A to 4D are graphs showing temperature variation depending on change in the conditions; FIGs. 5A and 5B are photographs showing particles of aluminum powder before and after reaction according to an exemplary embodiment; and FIG 6 is a flowchart of a plasma nano-powder synthesizing and coating method according to an exemplary embodiment.

The plasma nano-powder synthesizing and coating device 100 (hereinafter, referred to as a 'synthesizing and coating device') according to an exemplary embodiment includes a chamber 110 having a reaction unit 200 and a processing unit 300. Further, the synthesizing and coating device 100 includes a controller 500 for controlling elements constituting the same.

The reaction unit 200 of the synthesizing and coating device 100 is provided above the chamber 110 to occupy an upstream of gas, and includes a powder feeder 290, a mixed gas feeder 270 and a plasma torch 210 for forming a high-temperature plasma region 250 by generating an arc due to an electric current supplied in a plasma gas atmosphere supplied by a plasma gas feeder 230.

A structure for generating plasma or the plasma torch 210 is the same as a typical plasma generator, and thus detailed descriptions thereof will be omitted. As necessary, a plurality of plasma touches 210 may be provided.

As shown in FIG. 2D, the plurality of plasma torches 210a, 210b and 210c equiangularly branch without being aligned on the axis of the reaction unit 200 and are arranged above the reaction unit, thereby forming the plasma region 250 along the axial region of the reaction unit 200. FIG. 2D shows three plasma torches 210a, 210b and 210c, but not limited thereto. Alternatively, two, or four or more plasma torches 210 may be provided. In the case where the plasma torches 210 are spaced apart and equiangularly branch above the center of the reaction unit 200, the powder feeder 290 may be formed above the reaction unit 200. Thus, powder from the powder feeder 290 is supplied to the plasma region 250 in the reaction unit 200, and the supplied powder enters the center of the plasma region 250 immediately when being supplied, thereby having advantages in the light of reaction, synthesizing, etc.

The mixed gas feeder 270 supplies various kinds of gas in order to maintain an atmosphere of the reaction unit 200 or the processing unit 300 of the chamber 110 as desired. For example, hydrogen gas as a kind of reduction gas; C₂H₂ or the like as hydrocarbon gas, Ar or the like as inert gas may be supplied solely or mixedly as necessary.

Here, the controller 500 controls that feeding amounts of the plasma gas feeder 230 and the mixed gas feeder 270 can be adjusted by control valves (refer to 'MFC1' and 'MFC3').

The powder feeder 290 supplies the powder to the reaction unit 200. There are many methods of supplying the powder from the powder feeder 290 to the reaction unit 200. For instance, if a quantitative feeder (refer to 'powder feeder' of FIG. 1) for quantitatively supplying the powder supplies the powder into a pipe where Ar or the like gas is transferred at high speed, the powder is supplied together with gas into the reaction unit 200, so that the powder can reach the plasma region 250. The controller 500 controls that the amount of the carrier gas supplied at this time can be adjusted by the control valve (refer to 'MFC2' of FIG. 1).

In the powder feeder 290, different metals may be mixed and supplied through the gas supplying pipe while being mixed in the quantitative feeder. On the other hand, respective powders may be supplied to the plasma region 250 of the reaction unit 200 through different powder feeders 290. If the plurality of plasma torches 210 is provided, the powder feeder 290 may be placed in a center portion of the plasma torches. That is, the powder feeder 290 is provided so that the powder can be supplied to the axis of the plasma region 250, and react in the plasma region 250 for a time while undergoing melting, evaporation, etc. uniformly.

The powder feeder 290 may supply a plurality of powders. This is because the plurality of powders can be fused. Also, the supplied powders may be different in kind. That is, different kinds of powders among metal powder, carbon, ceramic and inorganic powder may be supplied, and heterogeneous metal, carbon, ceramic or inorganic materials react with each other in the reaction unit 200 or react even in the processing unit 300. Thus, different kinds of powders are supplied from the powder feeder 290.

Further, a nozzle unit 260 may be coupled to an outlet side of the reaction unit 200 and have a tapered cross-section to adjust the cross-section and the size of a channel and thus control speed or the like of fluid and powder. Further, the nozzle unit 260 may be sized corresponding to the length and width of the plasma region 250. Therefore, gas in the processing unit 300 is prevented from flowing backward to the reaction unit 200, so that the plasma region 250 can be more stably maintained. Further, temperature formed in the plasma region 250 can be effectively and stably maintained up to the outlet of the reaction unit 200, thereby enhancing reactivity of the powder.

As shown in FIGs. 2A and 2B, the nozzle unit 260 has various kinds of structures detachable to the chamber 110 so that it can be arranged between the reaction unit 200 and the processing unit 300 and adjust the width (see 'D1' and 'D2'), length and height (see 'H1' and 'H2') of the channel. The nozzle unit 260 may be coupled to the chamber 110 by a coupling means 285 such as a bolt, a nut, a clamp, etc.

That is, the nozzle unit 260 may be coupled in the form of a nozzle unit 260a having a diameter D1 and a length or height H1 as shown in a solid line of FIG. 2B, or as necessary in the form of a nozzle unit 260b having a diameter D2 and a length or height H2 as shown in a dotted line. In this case, the size of a reaction region collecting unit 287 to be described later may be varied depending on the sizes of the nozzle units 260a, 260b shown in the dotted line and solid line. The shape and size of the nozzle unit 260 are not limited to the above two examples, and may have various shapes, diameters, lengths and heights.

The reaction region collecting unit 287 is arranged between the nozzle unit 260 and the reaction unit 200 and includes a cooling member 280 for heat exchange with the powder so that the powder flowing between inner walls of the reaction unit 200 and the nozzle unit 260 can be collected. Here, a pipe line for supplying cooling water to the cooling member 280 is indicated by a reference numeral of '283'. This pipe line is attached to a surface 287s of the reaction region collecting unit 287, so that the powder cooled by the cooling member 280 can be collected.

Thus, the reaction region collecting unit 287 can collect the powder not supplied to the processing unit 300 through the nozzle unit 260 by a circulating flow behind a gap (refer to 'GAP' of FIG. 2B) between the nozzle unit 260 and an inner wall forming the chamber 110. As necessary, the nozzle unit 260 may be shaped not to form the 'GAP'.

In the reaction unit 200, the powder is evaporated or melted, or only a surface thereof may be melted by high temperature of the plasma region 250, and such evaporated or melted different metals may be synthesized. Accordingly, different kinds of powder can be simply and conveniently synthesized, and the powder can be evaporated.

In the reaction unit 200, as shown in FIG. 2, a temperature sensor 130 is installed for sensing the temperature inside the reaction unit 200, and a window 150 is provided for checking a state of the plasma region 250. FIGs. 3A and 3B are photographs showing flame states in the plasma region 250 observed through the window 150. FIG. 3A shows the flame state in the plasma region 250 when a low electric current is applied at 200torr, and FIG. 3B shows the flame state in the plasma region 250 when a high electric current is applied at 50torr. In FIGS. 3A and 3B, the topmost first photograph shows a position of about 10cm from the tip of the plasma torch 210, the second photograph shows a position of about 25cm from the tip of the plasma torch 210, the third photograph shows a position of about 45cm from the tip of the plasma torch 210, and the fourth photograph shows a position of about 75cm from the tip of the plasma torch 210, i.e., an upside of a material 330. Further, FIG. 3C is a photograph in the case of adding hydrogen at 50torr.

The flame at each position of FIG. 3B is stronger than the frame at each position of FIG. 3A, and it is thus appreciated that the temperature in the plasma region 250 of FIG. 3B is higher than that in the plasma region 250 of FIG. 3A. That is, the photographs show that the length of the plasma region 250 becomes longer and the temperature also rises if the degree of a vacuum is high. In comparison between FIG. 3A and FIG. 3C, the flame of the plasma region 250 becomes stronger when hydrogen is added.

The processing unit 300 is arranged in a downstream of the plasma flame, and placed under the chamber 110.

The processing unit 300 includes a supporter 310 for supporting the material 330, and a powder collecting unit 350 for collecting the powder scattered in the reaction unit 200.

The supporter 310 includes a cooling means (not shown) for cooling the material 330 and a heating means (not shown) for heating the material 330. For example, the material 330 may include a wafer, or a substrate material to be coated. On the surface of the material 330, a coating layer 355 coated with the powder is formed. At this time, the particle size, porosity, etc. of the coating layer 355 can be adjusted by the controller 500, which will be described later, so that the coating layer 355 can be formed with pores.

In this process, the synthesis of powder, in particular, the synthesis of plural powders may be achieved at the reaction unit 200, the processing unit 300 and the surface of the supporter 310. This synthesis of the powder may occur in a certain region, or may occur sequentially or simultaneously throughout various regions.

As shown in FIG. 2C, the coating layer 355 may be formed while moving not a typical material but a foil-shaped material on the supporter 310. An unwinder for unwinding a foil-shaped material wound is provided at one side, and a winder for winding it is provided at the other side, thereby moving the foil-shaped material 330 at constant speed. Like this, the coating layer 355 can be formed on the surface of the material while moving the material on the supporter 310. Thus, there is an advantage that the coating layer 355 can be successively, simply and conveniently formed on the foil-shaped material having a large area.

The processing region powder collecting unit 350 includes a receiving means shaped like a funnel having a wide upper portion surrounding the supporter 310 and a narrow lower portion in order to enlarge an area where the scattered powder contacts and receive the collected powder in the lower portion. Further, the processing region powder collecting unit 350 includes the cooling means (not shown) for cooling the funnel-shaped receiving means so that high-temperature powder can contact the funnel-shaped receiving means and be solidified. Thus, the evaporated and melted powder or minute powder can be more efficiently, simply and conveniently collected to thereby enhance economic feasibility.

A vacuum forming unit 410 forms a vacuum inside the chamber 110. The vacuum forming unit 410 uses a vacuum pump to exhaust gas from the chamber 110.

A flow control unit 420 is arranged in a pipe between the chamber 110 and the vacuum forming unit 410 as shown in FIG. 1, and controls how far the pipe will be opened and closed so that the degree of a vacuum in the chamber 110 and a plasma state in the reaction unit 200. Thus, the degree of a vacuum in the chamber 110 and the plasma state can be easily controlled.

An auxiliary powder collecting unit 430 is interposed between the chamber 110 and the vacuum forming unit 410 and collects the powder scattered outside the chamber 110. The auxiliary powder collecting unit 430 secondarily collects the powder not collected by the processing region powder collecting unit 350.

A lower casing 400 forms a bottommost portion of the chamber 110 and supports the reaction unit 200 and the processing unit 300 while making an outer appearance beautiful. The lower casing 400 accommodates the flow control unit 420 and the auxiliary powder collecting unit 430 therein.

With this configuration, operations of the synthesizing and coating device 100 will be described in detail with reference to FIGs. 1 to 6.

An electric arc is generated by an electric current based on supplied power, and gas supplied from the plasma gas feeder 230 has a plasma phase in the plasma torch 210, so that the plasma region 250 can be formed along the axial region of the reaction unit 200 (S510). The temperature of the plasma region 250 is several thousand degrees.

At a mixed gas feeding step (S520), mixed gas is supplied to the reaction unit 200. As described above, various kinds of gases may be selectively used as the mixed gas.

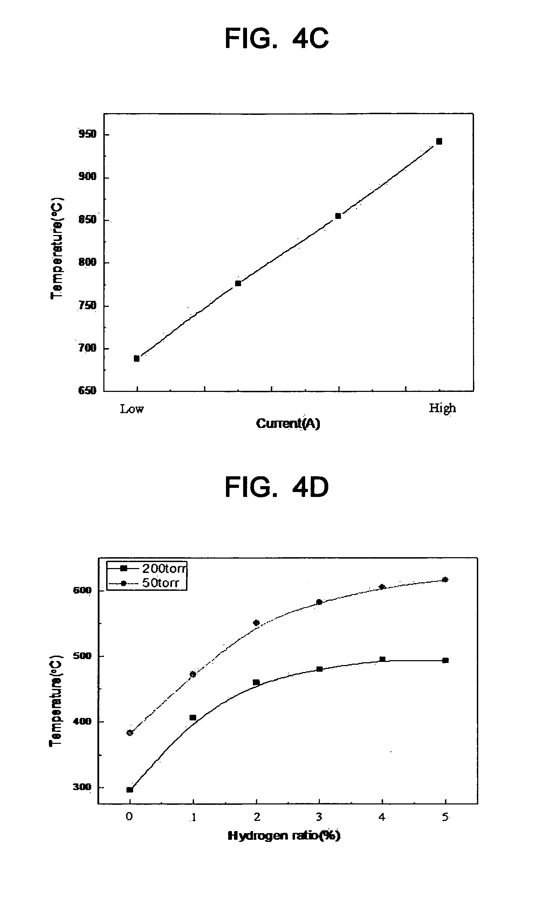

For example, in the case where hydrogen is used in the mixed gas, if the mixed gas feeder 270 supplies hydrogen gas by adjusting a hydrogen volumetric ratio under a vacuum condition of 50torr and 200torr, as shown in FIG 4D the temperature sensed by the temperature sensor 130 increases as compared with the case where the mixed gas is not supplied. Thus, the controller 500 controls the temperature of the reaction unit 200 by adjusting the amount of hydrogen gas supplied to the mixed gas. Here, the temperature sensed by the temperature sensor 130 is not temperature in a center portion of the plasma region 250 but temperature in the reaction unit 200 between the plasma region 250 and the wall of the reaction unit 200. This is because the temperature in the center portion of the plasma region 250 is too high to be sensed by the sensor.

At a step (S530) of forming a vacuum inside the chamber 110, the vacuum pump or the like is employed for exhausting gas inside the chamber 110 to the outside. As the chamber 110 is evacuated, unnecessary air or the like impurities other than gases introduced into a region where the reaction or coating occurs are removed, so that a compound can be synthesized or the coating layer 355 can be formed having high purity. Also, the vacuum may decrease an evaporation or a melting temperature of the powder supplied, and enhance a coupling force of powder.

Meanwhile, if the degree of a vacuum increases, the length of the plasma region 250 becomes longer, and thus the temperature rises. FIG. 4B shows that the temperature sensed by the temperature sensor 130 rises if the degree of a vacuum increases from about 200torr to about 50torr.

During this process, the flow control unit 420 may control the degree of a vacuum in the chamber 110 and the plasma state in the reaction unit 200 by adjusting the amount of exhausted fluid.

At a powder feeding step (S540), a nanometer or a few micro meter scale of powder is supplied to the plasma region 250 of the reaction unit 200 through the powder feeder 290.

Thus, in the reaction unit 200 or the processing unit 300, the powder may evaporated or melted, only a surface thereof may be melted, and a reaction of synthesizing the powders with each other occurs (S550). Thus, heterogeneous metal powder or the like can simply and conveniently reacts by changing the condition of the reaction unit 200 in accordance with the kinds of supplied metal, the size of a particle, etc.

The reacted powder is coated on to the material 330 by a particle velocity under vacuum pressure to thus form the coating layer 355 (S560). In this process, the powder may also be synthesized. That is, the evaporated or melted heterogeneous metals are bonded each other as a particle and form the coating layer 355. Further, by increasing the degree of vacuum or making the particle velocity faster, the particles constituting the coating layer 355 may collide to form not a particle having a spherical shape but a particle lengthwise crushed in a direction transverse to a collision direction of the particle. That is, according to this exemplary embodiment, there is an advantage that the heterogeneous powders can be synthesized in the reaction unit 200 in the processing unit 300 and form the coating layer 355.

Further, there is an advantage that various coating layers 355 can be formed since operating conditions inside the chamber 110 of the nano-powder synthesizing and coating device 100 can be controlled while forming the coating layer 355. This will be described below with reference to FIGs. 4A to 4D.

First, FIG 4A show that the temperature of the plasma region 250 becomes higher if the amount of Ar introduced into the chamber 110 decreases, but becomes lower if the amount of Ar increases in the state that a constant degree of a vacuum is maintained and a constant electric current is applied. Thus, it will be appreciated that the temperature of the plasma region 250 becomes higher, a stay time of the powder in the plasma region 250, is extended, if the amount of Ar supplied to the chamber 110 decreases. In other words, the stay time of the powder can be controlled by adjusting the supplying amount of Ar. Accordingly, the stay time or the temperature is controlled in consideration of the size, kind, etc. of the powder, so that a proper range in which the powder is melted or evaporated in the chamber 110 can be selected.

As shown in FIG. 4B, the result was that the temperature of the plasma region 250 becomes higher if the degree of a vacuum in the chamber 110 increases while a constant electric current is applied and a constant amount of Ar is maintained. Thus, the degree of a vacuum is adjusted in accordance with the size, kind, etc. of the supplied powder, thereby properly controlling a synthesizing or coating state of the powder.

FIG 4C shows that the temperature of the plasma region 250 is varied in almost proportion to the applied electric current if a constant degree of a vacuum and a constant amount of Ar are maintained. Thus, a user can select the applied electric current in accordance with a required temperature.

FIG. 4D is a graph showing change in the temperature of the plasma region 250 by changing a volumetric ratio of hydrogen added as an example of the mixed gas to Ar while a constant amount of Ar is maintained and a constant electric current is applied. The temperature of the plasma region 250 increases in proportion to the amount of additive hydrogen, and stops increasing when a certain or more amount of hydrogen is added. Therefore, it is possible to select an optimum amount of additive hydrogen.

The powder in the coating layer 355 formed maintains a spherical particle shapes as compared with that of the conventional chemical vapor deposition or plasma spray coating method, and may be thus formed with pores. Further, the coating layer 355 may be variously formed containing not single metal but heterogeneous metals, metal and ceramic, metal and inorganic powder, etc. Also, it is possible to make the velocity toward the coating layer 355 slowly, so that the coating layer 355 can have more porous structure. Accordingly, the coating layer 355 formed as above is less compact than that of the conventional chemical vapor deposition or plasma spray coating method, and has the pores, so that it can be applied to various new fields. For example, the coating layer 355 may function as a membrane, an electrochemical electrode, etc.

The powder reacting or not reacting in the reaction unit 200 moves to the processing unit 300 along the flow of plasma flame and forms the coating layer 355 or is collected outside the supporter 310 (S570). As described above, a region for collecting the powder is divided into the processing region powder collecting unit 350 formed around the supporter 310 of the processing unit 300 and the auxiliary powder collecting unit 430 formed between the chamber 110 and the vacuum forming unit 410. Thus, it is possible to collect relatively expensive powder efficiently, simply and conveniently. Further, some powder flowing in the reaction unit 200 along a circulating flow may be collected in the reaction region collecting unit 287.

Alternatively, if powder having very high purity is required, the plasma region 250 may be formed at a temperature higher than a temperature where the powder is evaporated, and all the evaporated powder may be collected. For example, the supporter 310 may be removed from the processing unit 300, or the supporter 310 may be covered with a cone-shaped collecting member instead of putting the material 330 on the supporter 310, so that all the reacted powder can be guided to the powder collecting units 350 and 430. Further, the powder collecting units 350 and 430 may be provided with the cooling means for cooling the temperature through heat exchange, thereby more effectively collecting the powder.

The controller 500 can control the state of powder reacting in the reaction unit 200 by controlling at least one of the degree of a vacuum in the chamber 110, the electric current applied to the plasma torch 210, and the amount of mixed gas supplied from the mixed gas feeder 270. Further, the controller 500 may control the temperature in accordance with change in the amount of supplying gas, the electric current, etc. on the basis of a value previously input by analyzing various experimental data. Also, the controller 500 controls the flow rate control unit 420 to control the degree of a vacuum or a plasma state in the chamber 110.

As shown in FIG. 4C, since the temperature increases in approximate proportion to the increase of the electric current, such information is previously input to the controller 500 and used for the control.

Likewise, the controller 500 can control at least one of the degree of a vacuum inside the chamber 110, the electric current supplied to the plasma torch 210, and the amount of mixed gas supplied from the mixed gas feeder 270, thereby controlling the coating layer 355 coated on the surface of the material 330 supported by the supporter 310.

If powder of various materials to be used as a raw material is transferred to the reaction unit 200 through the quantitative feeder, the powder may be evaporated, melted, synthesized or undergo the like reaction in the plasma region 250. The reacted powder is coated onto the material 330 of the processing unit 300 to form the coating layer 355, and collected by the powder collecting units 350 and 430 arranged around the supporter 310 or in the like. The synthesizing and coating device in this exemplary embodiment is advantageous to work with various kinds of powder and various reaction conditions since the controller 500 can control the length and temperature of the plasma region 250 in accordance with clectric current, gas flow rate, and vacuum conditions (e.g., vacuum atmosphere of several tens to hundreds of Torr) as combination of the plasma spray coating method and the vacuum deposition method. Also, the coating may be achieved as different kinds of powders are synthesized.

FIG. 5B is an enlarged photograph of the coating layer 355 coated by the nano-powder synthesizing and coating device 100 according to an exemplary embodiment. Here, aluminum powder was used, and the coating layer 355 of FIG. 5B is more increased in pores than the commercial aluminum powder (see FIG. 5A), and the size and shape of particles thereof are also more uniform without crushing.

That is, according to an exemplary embodiment, the high temperature of the plasma region can be variously, easily and conveniently controlled in accordance with the kinds of powder and various synthesizing conditions of powder. Also, the heterogeneous powder can be simply and conveniently synthesized in the plasma region. Further, the heterogeneous powder can be simultaneously synthesized and coated. Further, the size, shape, porosity, etc. of metal to be coated can be controlled, and nano-scale particles with uniform size form a porous coating layer having pores. Further, the powder can have high purity. Further, the supplied or reacted powder can be simply and conveniently collected.

As apparent from the above description, a high-temperature range of plasma can be variously, simply and conveniently controlled in accordance with the kind of powder and various synthesizing conditions of powder.

Also, heterogeneous powder can be simply and conveniently synthesized in a plasma range.

Further, heterogeneous powder can be simultaneously synthesized and coated.

Further, the size and porosity of metal to be coated are controllable, thereby forming a coating layer with pores.

Further, powder can have high purity.

Further, supplied or reacted powder can be simply and conveniently collected.

Further, a foil-shaped or film-shaped material can be simply and successively coated.

Although a few exemplary embodiments have been shown and described, it will be appreciated by those skilled in the art that changes may be made in these exemplary embodiments without departing from the principles and spirit of the invention, the scope of which is defined in the appended claims and their equivalents.

## Claims

1. A plasma nano-powder synthesizing and coating device comprising:
a chamber which forms a sealed space, and comprises a reaction unit provided at one side and a processing unit provided at the other side,
the reaction unit provided in an upstream of gas flowing in the chamber, having a high-temperature plasma region formed by a plasma torch generating plasma with an applied electric current, and comprising a mixed gas feeder to supply mixed gas to the reaction unit and a powder feeder to supply powder to the reaction unit, and
the processing unit provided in a downstream of gas flowing in the chamber, and comprising a supporter to support a material; and
a vacuum forming unit which forms a vacuum inside the chamber,
the powder being supplied to the reaction unit and reacting in the plasma region of the reaction unit, and the reacted powder being synthesized in the reaction unit, the processing unit and a surface of the supporter, and coated on a surface of the material of the supporter to form a coating layer.

2. The plasma nano-powder synthesizing and coating device according to claim 1, wherein the powder supplied from the powder feeder comprises a plurality of powders, and
the powder being supplied comprises different kinds of powders among metal powder, carbon, ceramic and inorganic powder.

3. The plasma nano-powder synthesizing and coating device according to claim 1, further comprising a nozzle unit provided between the reaction unit and the processing unit and detachable to the chamber so that a channel can be adjusted in width and length.

4. The plasma nano-powder synthesizing and coating device according to claim 3, further comprising a reaction region collecting unit provided between the nozzle unit and the reaction unit and comprising a cooling member capable of exchanging heat with powder so that the powder circulating between the nozzle unit and an inner wall of the reaction unit can be collected.

5. The plasma nano-powder synthesizing and coating device according to claim 1, further comprising a processing region powder collecting unit provided in the processing unit and arranged in the vicinity of the supporter to collect the powder scattered from the reaction unit.

6. The plasma nano-powder synthesizing and coating device according to claim 5, further comprising an auxiliary powder collecting unit interposed between the chamber and the vacuum forming unit and collecting the powder scattered outside the chamber.

7. The plasma nano-powder synthesizing and coating device according to claim 1, further comprising a flow control unit provided in a pipe between the chamber and the vacuum forming unit and controlling the flow rate in the pipe so that a degree of a vacuum in the chamber and so a plasma state in the reaction unit can be adjusted.

8. The plasma nano-powder synthesizing and coating device according to claim 1, wherein the material supported by the supporter has a film or foil shape, and is provided to be unwound at one side but wound at the other side so that a surface of the material can be coated while the material moves.

9. The plasma nano-powder synthesizing and coating device according to claim 1, wherein the plasma torch is provided in plural to equally branch without being aligned on the axis of the reaction unit and arranged above the reaction unit, each plasma torch synthesizing and forming the plasma region along the axial region of the reaction unit, and
the powder feeder is arranged above the reaction unit so that the powder can be supplied to the plasma region formed along the axial region of the reaction unit.

10. A plasma nano-powder synthesizing and coating method comprising:
forming a high-temperature plasma region by a plasma torch generating plasma with an electric current supplied to a reaction unit in a chamber which has a sealed space and comprises the reaction unit at one side and a processing unit at the other side;
supplying mixed gas to the reaction unit;
forming a vacuum inside the chamber;
supplying powder to the reaction unit;
making the powder react in the plasma region; and
synthesizing or coating the reacted powder on a surface of a material supported and provided in the processing unit.

11. The plasma nano-powder synthesizing and coating method according to claim 10, the powder comprises different kinds of powders among metal powder, carbon, ceramic and inorganic powder.

12. The plasma nano-powder synthesizing and coating method according to claim 10, further comprising collecting the powder scattered in the reaction unit in the vicinity of the processing unit.

13. The plasma nano-powder synthesizing and coating method according to claim 10, further comprising controlling reaction or synthesis of the powder in the reaction unit by adjusting at least one of a degree of a vacuum inside the chamber, an electric current applied to the plasma torch, and the flow rate of mixed gas supplied from a mixed gas feeder.

14. The plasma nano-powder synthesizing and coating method according to claim 10, further comprising controlling a coating layer coated on a surface of a material by adjusting at least one of a degree of a vacuum inside the chamber, an electric current supplied to the plasma torch, and an flow rate of mixed gas supplied from a mixed gas feeder.

15. The plasma nano-powder synthesizing and coating method according to claim 10, wherein the metal powder comprises aluminum, nickel and other metal particles.

16. The plasma nano-powder synthesizing and coating method according to claim 10, wherein the mixed gas comprises one of reduction gas, hydrocarbon gas and inert gas.

17. The plasma nano-powder synthesizing and coating method according to claim 10, further comprising collecting the powder solidified inside the chamber or cold-trapped in the pipe to the vacuum forming uint.

18. The plasma nano-powder synthesizing and coating method according to claim 10, further comprising preparing a nozzle unit provided between the reaction unit and the processing unit and detachable to the chamber so that a channel can be adjusted in width and length.

19. The plasma nano-powder synthesizing and coating method according to claim 18, further comprising preparing a reaction region collecting unit provided between the nozzle unit and the reaction unit and comprising a cooling member capable of exchanging heat with powder so that the powder recirculating in the space between the nozzle unit and an inner wall of the reaction unit can be solidified and collected.

20. The plasma nano-powder synthesizing and coating method according to claim 10, wherein the material supported by the supporter has a film or foil shape and is provided to be unwound at one side but wound at the other side, and the method comprising coating a surface of the material while the material moves.

21. The plasma nano-powder synthesizing and coating method according to claim 10, further comprising
providing the plasma torch in plural to equally branch without being aligned on the axis of the reaction unit and arranged above the reaction unit, each plasma torch forming the plasma region along the axis of the reaction unit, and
arranging a powder feeder above the reaction unit so that the powder can be supplied to the plasma region formed along the axis of the reaction unit.
